(19) Europäisches Patentamt
European Patent Office
Office européen des brevets

(11) **EP 3 683 968 B1**

(12) **EUROPÄISCHE PATENTSCHRIFT**

(45) Veröffentlichungstag und Bekanntmachung des Hinweises auf die Patenterteilung:
**02.08.2023   Patentblatt 2023/31**

(21) Anmeldenummer: **20152420.4**

(22) Anmeldetag: **17.01.2020**

(51) Internationale Patentklassifikation (IPC):
**H03L 7/099** *(2006.01)*   **H03L 7/22** *(2006.01)*
**H03L 7/093** *(2006.01)*

(52) Gemeinsame Patentklassifikation (CPC):
**H03L 7/22; H03L 7/093; H03L 7/099;** H03L 2207/12

(54) **VORRICHTUNGEN UND VERFAHREN ZUM ERZEUGEN EINES BREITBANDIGEN FREQUENZSIGNALS**

METHOD AND DEVICES FOR CREATING A BROADBAND FREQUENCY SIGNAL

DISPOSITIFS ET PROCÉDÉ DE GÉNÉRATION D'UN SIGNAL DE FRÉQUENCE À LARGE BANDE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.01.2019   DE 102019101261**

(43) Veröffentlichungstag der Anmeldung:
**22.07.2020   Patentblatt 2020/30**

(73) Patentinhaber: **Fraunhofer-Gesellschaft zur Förderung
der angewandten Forschung e.V.
80686 München (DE)**

(72) Erfinder:
• **WELP, Benedikt
53343 Wachtberg (DE)**
• **POHL, Nils
53343 Wachtberg (DE)**

(74) Vertreter: **2SPL Patentanwälte PartG mbB
Landaubogen 3
81373 München (DE)**

(56) Entgegenhaltungen:
US-A- 5 267 182          US-A- 5 939 951
US-A1- 2005 186 918     US-A1- 2015 295 582
US-B1- 8 264 258

## Beschreibung

### Technisches Gebiet

Ausführungsbeispiele befassen sich mit Vorrichtungen zum Erzeugen von breitbandigen Frequenzsignalen und mit Verfahren zum Erzeugen von breitbandigen Frequenzsignalen. Weitere Ausführungsbeispiele befassen sich mit einem Hochfrequenzgerät zum Erzeugen von Hochfrequenzsignalen. Beispiele befassen sich mit Vorrichtungen umfassend einen Phasenregelkreis zum Stabilisieren von Oszillatoren und zum Erzeugen breitbandigstabilisierter Frequenzsignale.

### Hintergrund

Oszillatoren (z.B. spannungsgesteuerte Oszillatoren VCO; engl. voltage controlled oscillator) können dazu verwendet werden, breitbandige Signale (z.B. Frequenzrampen) zu erzeugen. Unter Verwendung einer Phasenregelschleife (engl.: PLL; phase locked loop) kann eine Frequenz eines Ausgangssignals eines spannungsgesteuerten Oszillators eingestellt und stabilisiert werden. Als Referenzsignalgeber kommt beispielsweise ein frequenzmäßig hochstabiler Quarz-Oszillator zum Einsatz, der niederfrequent (z.B. im Vergleich zu einer Frequenz des Ausgangssignals des VCOs, z.B. mit einer Frequenz von 100MHz oder weniger) ist und bei einer festen Frequenz betrieben werden kann.

Ein Ausgangssignal des VCOs kann durch einen statischen Frequenzteiler und einen einstellbaren Teiler in einem Rückkoppelpfad der PLL geteilt und mit einem geteilten Referenzsignal des Quarz-Oszillators mittels eines PFDs (Phasen-Frequenz-Diskriminator) verglichen werden. Die Phasendifferenz, die der PFD ausgibt, dient als Regelgröße und wird über eine Ladungspumpe (engl.: CP: Charge Pump) und einen Schleifenfilter in eine Regelspannung umgewandelt, die die Ausgangsfrequenz des Oszillators (VCO) derart einstellt, dass die Phasendifferenz der beiden Eingangsfrequenzen am PFD gleich null ist.

In modernen Anwendungen können breitbandige Signale benötigt werden, deren Erzeugung schwierig und aufwändig ist. Bekannte Oszillatoren stellen etwa nur eine begrenzte Bandbreite zur Verfügung. Die relative Bandbreite dieser Oszillatoren liegt typischerweise bei weniger als 20%.

Ferner führt das Erzeugen eines breitbandigen Signals dazu, dass im Rückkoppelpfad der Phasenregelschleife sehr unterschiedliche Teilerwerte von Frequenzteilern verwendet werden müssen. Dies kann aufgrund einer vom Wertebereich der Teilerwerte abhängigen Verstärkung der PLL zu hohen Schwankungen der Verstärkung der PLL führen. Beispielsweise sind Phasenregelschleifen PLLs mit hoher Variation einer Schleifenverstärkung der PLLs bei sehr breitbandigen Signalen bekannt. Es kann erforderlich sein, die Variation zu verringern, um das breitbandige Signal zuverlässiger zu erzeugen. Eine hohe Variation der Schleifenverstärkung kann den Frequenzbereich einschränken, in dem die PLL in der Lage ist, den Oszillator zu stabilisieren.

Aus der US 2015 / 0 295 582 A1 sind Beispiele gezeigt, die eine Takterzeugungsschaltung mit einer ersten Phasenregelschleife (PLL) und einer zweiten PLL bereitstellen, die parallel miteinander gekoppelt sind und dasselbe Rückkopplungssignal empfangen. Die erste und die zweite PLL erzeugen jeweilige Ausgangssignale, die kombiniert werden, um ein Ausgangstaktsignal zu erzeugen. Eine Version des Ausgangstaktsignals kann als Rückkopplungssignal an die erste und zweite PLL zurückgegeben werden. In einigen Ausführungsformen kann die zweite PLL einen Schalter enthalten, um die zweite PLL selektiv zu schließen, nachdem die erste PLL gesperrt wurde.

Die Publikationen US 8 264 258 B1, US 5 267 182 A, US 5 939 951 A und US 2005/186918 A1 befassen sich ebenfalls mit der Erzeugung von Signalen.

Es besteht ein Bedürfnis nach verbesserten Konzepten, die eine Erzeugung von Signalen mit erhöhter Bandbreite ermöglichen.

### Zusammenfassung

Gemäß den Patentansprüchen werden Konzepte bereitgestellt, um dieses Bedürfnis zu erfüllen.

Ein Ausführungsbeispiel der vorliegenden Erfindung betrifft eine Vorrichtung zum Erzeugen eines breitbandigen Frequenzsignals $f_{out}$. Die Vorrichtung umfasst einen ersten gesteuerten Oszillator und einen zweiten gesteuerten Oszillator. Der erste gesteuerte Oszillator und der zweite gesteuerte Oszillator sind in der gemeinsamen Phasenregelschleife umfasst und werden basierend auf einem Spannungssignal gesteuert. Ein Mischer ist ausgebildet, durch Mischen eines Ausgangssignals des ersten gesteuerten Oszillators und eines Ausgangssignals des zweiten gesteuerten Oszillators das breitbandige Frequenzsignal zu erzeugen. Der der Mischer ist in der gemeinsamen Phasenregelschleife umfasst und der erste und der zweite gesteuerte Oszillator sind ausgebildet, bei einer Änderung des Spannungssignals eine gegenläufige Frequenzveränderung zu bewirken. Der Ausgang des Mischers ist mit einem Rückkoppelpfad der gemeinsamen Phasenregelschleife gekoppelt, zum Rückkoppeln des breitbandigen Frequenzsignals über die gemeinsame Phasenregelschleife. Das Spannungssignal wird durch die gemeinsame Phasenregelschleife basierend auf dem rückgekoppelten breitbandige Frequenzsignal erzeugt.

Beispielsweise ist der erste gesteuerte Oszillator ausgebildet, um ein Ausgangssignal einer ersten Bandbreite innerhalb eines ersten Frequenzbereichs auszugeben und der zweite gesteuerte Oszillator ausgebildet, um ein Ausgangssignal einer zweiten Bandbreite innerhalb eines zweiten Frequenzbereichs, der vom ersten Frequenzbereich abweicht, auszugeben. Durch den Mischvorgang kann das breitbandige Frequenzsignal mit einer Bandbreite erzeugt werden, die größer ist als die erste oder zweite Bandbreite. Beispielsweise kann eine Bandbreite des breitbandigen Frequenzsignals bis zu hin zu der Summe aus erster und zweiter Bandbreite realisiert werden.

Um die Bandbreite des generierten Signals zu erhöhen, können zwei sehr hochfrequente gesteuerte Oszillatoren bereitgestellt werden, die jeweils eine hohe absolute Bandbreite besitzen. Die gesteuerten Oszillatoren können spannungsgesteuerte Oszillatoren (VCO) oder digitalgesteuerte Oszillatoren umfassen. Beispielsweise weisen die gesteuerten Oszillatoren zwei aneinander angrenzende Frequenzbereiche auf, sodass der Mischer Signale mit kombinierter Bandbreite beider gesteuerter Oszillatoren ausgeben kann.

Beispielsweise können durch Verwendung zweier gesteuerter Oszillatoren stabilisierte Ausgangssignale mit reduziertem trägernahem Phasenrauschen erzeugt werden. Beispielsweise können für die beiden gesteuerten Oszillatoren gegenläufige Tune-Spannungen (z.B. am Eingang des Oszillators anliegende Steuerspannung im Betrieb des Oszillators) oder differentielle Tune-Spannungen zur Erzeugung breitbandiger Ausgangssignale bereitgestellt werden. Störeinkopplungen, die z.B. auf diese beiden Tune-Spannungen im Gleichtakt einkoppeln, können durch den Mischvorgang (Differenzfrequenz), etwa unter Voraussetzung gleicher oder genügend ähnlicher Abstimmteilheiten der Oszillatoren, kompensiert oder ausgelöscht werden.

Beispielsweise umfasst die Vorrichtung eine dem ersten und dem zweiten gesteuerten Oszillator gemeinsam zugeordnete Referenzsignalquelle (z.B. Quarz-Oszillator) zum Erzeugen eines Referenzsignals.

Gemäß dem vorher genannten Ausführungsbeispiel ist eine dem ersten und dem zweiten gesteuerten Oszillator gemeinsam zugeordnete Phasenregelschleife vorgesehen. Mit anderen Worten kann für beide Oszillatoren eine einzige Phasenregelschleife verwendet werden. Das zuvor genannte gemeinsame Referenzsignal kann an den Phasen-Frequenz-Diskriminator oder Phasen-Frequenz-Diskriminator der gemeinsamen Phasenregelschleife gekoppelt werden. Ferner kann in einem Rückkoppelpfad der gemeinsamen Phasenregelschleife das breitbandige Frequenzsignal, z.B. das Ausgangssignal des Mischers, an den Phasen-Frequenz-Diskriminator geleitet werden. Beispielsweise ist entsprechend der Ausgang des Mischers mit der Phasenregelschleife gekoppelt, um ein Rückkoppeln des breitbandigen Frequenzsignals über die gemeinsame Phasenregelschleife zu ermöglichen. Die gemeinsame Phasenregelschleife kann ausgebildet sein, um beispielsweise mittels des Phasen-Frequenz-Diskriminators oder im Signalpfad hinter dem Phasen-Frequenz-Diskriminator ein Signal (z.B. Spannungssignal) zu erzeugen. Die Vorrichtung kann ausgebildet sein, basierend auf diesem Signal ein Steuersignal oder Eingangssignal sowohl für den ersten gesteuerten Oszillator als auch für den zweiten gesteuerten Oszillator zu erzeugen.

Der Begriff gekoppelt kann beispielsweise eine direkte Verbindung zwischen Elementen bezeichnen, oder alternativ eine Verbindung von Elementen mit beispielsweise weiteren Signalverarbeitungseinheiten wie Filter, etc. in einem Pfad zwischen den Elementen bezeichnen.

Mittels der einen, gemeinsamen Phasenregelschleife können somit zwei Oszillatoren in effizienter Weise angesteuert oder betrieben bzw. stabilisiert werden. Durch die vorgeschlagene Vorrichtung kann ein Schaltungsaufwand der Vorrichtung zur Erzeugung breitbandiger Signale unter Verwendung zweier hochfrequenter Oszillatoren reduziert werden. Ferner kann beispielsweise im Vergleich zu einer Vorrichtung mit zwei Phasenregelschleifen ein besseres (z.B. geringeres) In-Loop-Phasenrauschen erreicht werden, da das breitbandige Frequenzsignal (z.B. das Ausgangssignal der Vorrichtung) als Signal dient, auf das geregelt wird (z.B. im Gegensatz zur direkten Verwendung der Ausgangssignale der gesteuerten Oszillatoren). Zudem können damit insgesamt kleinere Teilungsfaktoren im Rückkoppelpfad der Phasenregelschleife gewählt werden.

Ferner kann durch Verwendung einer gemeinsamen Phasenregelschleife die Notwendigkeit der Synchronisation zweier Phasenregelschleifen vermieden werden. Beispielsweise können breitbandige Signale (z.B. Frequenzrampen) mit erhöhter Linearität mittels des Ausgangssignals (beispielsweise des Signals hinter dem Mischer) erzeugt werden (wie z.B. bei FMCW-Radarsystemen benötigt), bei Vermeidung eines hohen schaltungstechnischen Aufwands, einer hohen Verlustleistung durch die zwei Phasenregelschleifen und/oder eines höheren In-Loop-Phasenrauschens (da sich z.B. das Phasenrauschen zweier Phasenregelschleifen durch den Mischprozess summiert).

Um das breitbandige Frequenzsignal zu erzeugen, ist eine gegenläufige Frequenzänderung der Ausgangssignale der beiden gesteuerten Oszillatoren vorgesehen. Um mittels eines einzigen Phasenregelkreises zwei Oszillatoren zu stabilisieren, die gegenläufige Frequenzänderungen ihrer Ausgangssignale bewirken (um breitbandige Ausgangssignale erzeugen zu können), werden verschiedene Konzepte bereitgestellt.

Beispielsweise können gemäß einem ersten Konzept der erste und der zweite gesteuerte Oszillator ausgebildet sein, bei einer Änderung einer Eingangsspannung eine gleichläufige Frequenzveränderung zu bewirken, sie können mit anderen Worten zumindest qualitativ ein gleiches Übertragungsverhalten aufweisen. Beispielsweise kann bei gleichem Übertragungsverhalten der Oszillatoren eine niedrige Eingangsspannung je eine niedrige Ausgangsfrequenz bewirken und eine hohe Eingangsspannung je eine hohe Ausgangsfrequenz bewirken. In diesem Fall kann vorgesehen sein, dass am Eingang eines der beiden gesteuerten Oszillatoren eine ein Steuersignal des Oszillators invertierende Signalverarbeitungseinheit angeordnet ist. Beispielsweise ist zwischen einem (z.B. gemeinsamen) Schleifenfilter der Phasenregelschleife und dem Eingang des einen gesteuerten Oszillators ein zusätzlicher Filter (invertierender Filter, z. B. Subtrahierverstärker) angeordnet, der das Tune-Spannungssignal z.B. invertiert und/oder derart konvertiert (z.B. durch Hinzufügen einer Offset-Spannung), dass die Abstimmkennlinien beider Oszillatoren von den erzeugten Regelspannungen gegenläufig komplett durchfahren werden können, beispielsweise, um eine Maximierung der möglichen Bandbreite des Ausgangssignals (z.B. des Signals $f_{out}$) zu erhalten. Mit anderen Worten kann beispielsweise das Steuersignal für den zweiten Oszillator basierend auf dem Steuersignal des ersten Oszillators erzeugt werden.

Alternativ kann gemäß einem zweiten Konzept vorgesehen sein, dass der erste und der zweite gesteuerte Oszillator ausgebildet sind, bei einer Änderung einer Eingangsspannung eine gegenläufige Frequenzveränderung zu bewirken. Bei derartigem, entgegengesetztem Übertragungsverhalten der Oszillatoren kann entsprechend auf die Invertierung des einen Signals verzichtet werden, sodass der zusätzliche Filter beispielsweise vermieden werden kann und ein Schaltungsaufwand weiter reduziert werden kann.

Aufgrund der gemeinsamen Erzeugung der Tune-Spannungen für beide gesteuerten Oszillatoren kann sich beispielsweise eine leicht reduzierte Störunterdrückung der Tune-Spannungen ergeben. Besonders herkömmliche PLL-Verfahren, bei denen ein Oszillator mit einem Phasenregelkreis über eine single-ended Tunespannung stabilisiert wird, leiden unter der hohen Störanfälligkeit der Tunespannung gegenüber Störsignaleinkopplungen. Daher werden Konzepte zur Verbesserung der Störunterdrückung vorgeschlagen.

Beispielsweise umfasst die gemeinsame Phasenregelschleife der Vorrichtung jeweils einen separaten Schleifenfilter für einen gesteuerten Oszillator. Die Phasenregelschleife ist mit anderen Worten ausgebildet, für jeden der beiden gesteuerten Oszillatoren ein eigenes Steuersignal zu erzeugen. Zum Beispiel wird im Unterschied zu anderen Konzepten die zweite Tune-Spannung für den zweiten Oszillator nicht aus der ersten Tune-Spannung abgeleitet, sondern beide Tune-Spannungen können aus einem gleichen Signal der Phasenregelschleife, z.B. aus einer Ausgangsspannung einer Charge Pump (CP, Ladungspumpe) der Phasenregelschleife generiert werden.

Zum Beispiel weisen beide gesteuerten Oszillatoren eine ähnliche Abstimmsteilheit auf und die Leitungen von der Charge Pump zu den einzelnen, separaten Schleifenfiltern können sehr kurz ausgebildet sein, um Störeinkopplungen zu verringern. Beispielsweise weicht die Abstimmsteilheit des einen gesteuerten Oszillators von der Abstimmsteilheit des anderen gesteuerten Oszillators um weniger als 10 % (oder weniger als 5 % oder weniger als 3 %) von der Abstimmsteilheit des anderen gesteuerten Oszillators ab. Die hinter den Schleifenfiltern liegenden Tune-Spannungen können als differentielles Tune-Spannungspaar bezeichnet werden, bei denen Störeinkopplungen durch den Mischprozess der beiden gesteuerten Oszillatoren reduziert oder eliminiert werden können.

Entsprechend einem Beispiel zur Reduzierung des Einflusses von Störkopplungen umfasst die gemeinsame Phasenregelschleife der Vorrichtung eine differentielle Ladungspumpe, wobei ein positiver Ausgang der differentiellen Ladungspumpe an den ersten gesteuerten Oszillator und ein negativer Ausgang der differentiellen Ladungspumpe an den zweiten gesteuerten Oszillator gekoppelt ist. Mit anderen Worten kann eine Modifikation der Ladungspumpe, bei der diese in zwei gegenläufig arbeitende Teile aufgeteilt wird, bewirken, dass differentielle Ausgangsspannungen der Ladungspumpe erzeugt werden. Diese können durch jeweilige Schleifenfilter auf die Arbeitsbereiche der gesteuerten Oszillatoren angepasst werden. Gleichtakstöreinkopplungen können dadurch wiederum durch den Differenz-Mischprozess der beiden gesteuerten Oszillatoren (unter Voraussetzung ähnlicher Abstimmsteilheiten) reduziert oder eliminiert werden. Alternativ zu einer differentiellen Ladungspumpe kann es möglich sein, einen Verstärker oder eine andersartige Signalverarbeitungseinheit mit differentiellen Ausgängen einzusetzen. Beispielsweise kann auch zwischen einem Ausgang einer nicht-differentiellen Ladungspumpe und einem der beiden Schleifenfilter eine invertierende Signalverarbeitungseinheit angeordnet sein.

Es kann vorgesehen sein, dass die Phasenregelschleife ferner einen zusätzlichen gesteuerten Oszillator und einen zusätzlichen Mischer im Rückkoppelpfad der Phasenregelschleife umfasst. Dadurch kann eine Frequenz eines Rückkoppelsignals der Phasenregelschleife (z.B. basierend auf dem breitbandigen Frequenzsignal) mittels des zusätzlichen gesteuerten Oszillators und des zusätzlichen Mischers erhöht werden. Das Mischen auf eine höhere Frequenz bewirkt eine relative Verringerung des Abstands zwischen minimaler und maximaler Signalfrequenz des rückgekoppelten Signals im Signalpfad hinter dem zusätzlichen gesteuerten Oszillator. Beispielsweise ist zwischen dem zusätzlichen Mischer und dem Phasen-Frequenz-Diskriminator ein einstellbarer Frequenzteiler angeordnet. Aufgrund des geringeren relativen Frequenzbereichs der am einstellbaren Frequenzteiler empfangenen Signale kann ein benötigtes Verhältnis von maximalem Teilerwert und minimalem Teilerwert des einstellbaren Frequenzteilers zum Teilen der Frequenz des Rückkoppelsignals verringert werden. Da eine Schwankung oder Variation einer Schleifenverstärkung der Phasenregelschleife von dem einstellbaren Frequenzteiler abhängig sein kann, ist es aufgrund des verringerten Verhältnisses der Teilerwerte möglich, eine Variation der Schleifenverstärkung der Phasenregelschleife zu reduzieren.

Beispielsweise ist eine obere Grenzfrequenz des ersten gesteuerten Oszillators größer oder gleich einer unteren Grenzfrequenz des zweiten gesteuerten Oszillators. Mit anderen Worten können die Frequenzbereiche der beiden gesteuerten Oszillatoren überlappen. Dadurch kann beispielsweise ein breitbandiges Frequenzsignal mit Frequenzen von 0 Hz (bei gleicher Frequenz der Ausgangssignale der gesteuerten Oszillatoren) bis hin zu einer Frequenz, die einem Frequenzunterschied zwischen einer unteren Grenzfrequenz des ersten Oszillators und einer oberen Grenzfrequenz des zweiten Oszillators entspricht, (bei maximaler Ausgangsfrequenz des einen gesteuerten Oszillators und minimaler Ausgangsfrequenz des anderen Oszillators) erzeugt werden.

Alternativ kann die obere Grenzfrequenz des ersten Oszillators kleiner sein, als die untere Grenzfrequenz des zweiten Oszillators. Der Abstand dieser beiden Frequenzen kann gleich der unteren Grenzfrequenz des Ausgangssignals sein.

Beispielsweise entspricht eine Bandbreite des erzeugten breitbandigen Frequenzsignals der Summe jeweiliger Bandbreiten der Ausgangssignale des ersten gesteuerten Oszillators und des zweiten gesteuerten Oszillators. Beispielsweise können beide gesteuerte Oszillatoren jeweilige Ausgangssignale mit einer Bandbreite von 20 GHz erzeugen, sodass das breitbandige Frequenzsignal eine Bandbreite von 40 GHz aufweisen kann.

Beispielsweise weist das erzeugbare breitbandige Frequenzsignal eine Bandbreite von zumindest 5 GHz (oder von zumindest 10 GHz, von zumindest 15 GHz, von zumindest 20 GHz, von zumindest 25 GHz, von zumindest 30 GHz, von zumindest 35 GHz, von zumindest 40 GHz, oder von zumindest 50 GHz) auf. Beispielsweise weist das erzeugbare breitbandige Frequenzsignal eine relative Bandbreite von mehr als 10 % (oder von mehr als 15 %, von mehr als 20 %, von mehr als 25 % oder von mehr als 30 %) auf. Die vorgeschlagene Vorrichtung kann es ermöglichen, sehr breitbandige Signale unter Verwendung lediglich einer Phasenregelschleife mit reduziertem Schaltungsaufwand zu erzeugen. Eine maximale relative Bandbreite bei erzeugten Signalen mit einer minimalen Frequenz von 0 Hz kann mit diesem Verfahren z.B. 200% betragen.

Beispielsweise ist eine untere Grenzfrequenz der Ausgangssignale der gesteuerten Oszillatoren größer als 100 MHz (oder größer als 500 MHz, größer als 1 GHz, größer als 5 GHz, größer als 10 GHz, größer als 20 GHz, größer als 60 GHz, größer als 80 GHz, größer als 100 GHz, größer als 150 GHz, oder größer als 200 GHz) und/oder kleiner als 300 GHz (oder kleiner als 200 GHz, oder kleiner als 100 GHz).

Gemäß einem Beispiel ist die Vorrichtung ausgebildet, ein breitbandiges Rampensignal zu erzeugen, aber auch monofrequente oder andersartig geformte Signale sind möglich (Frequency Shift Keying/Frequency Hopping). Das Rampensignal kann ein Signal mit linear ansteigender oder linear absteigender Signalfrequenz sein. Beispielsweise ist das breitbandige Frequenzsignal ein Radarsignal, ein Mobilfunksignal und/oder ein Messsignal.

Ein Beispiel der Vorrichtung umfasst einen zusätzlichen gesteuerten Oszillator und einen zusätzlichen Mischer im Rückkoppelpfad der gemeinsamen Phasenregelschleife. Dadurch kann eine Frequenz eines Rückkoppelsignals der gemeinsamen Phasenregelschleife mittels des zusätzlichen gesteuerten Oszillators und des zusätzlichen Mischers erhöht werden.

Beispielsweise ist der zusätzliche Mischer im Rückkoppelpfad der gemeinsamen Phasenregelschleife zwischen einem statischen Frequenzteiler und einem einstellbaren Frequenzteiler angeordnet. Durch den bereitgestellten zusätzlichen Mischvorgang kann ein Verhältnis von maximaler Frequenz zu minimaler Frequenz des Signals am Eingang des einstellbaren Teilers reduziert sein. Dadurch kann ein relativer Wertebereich benötigter Teilerwerte des einstellbaren Frequenzteilers verringert werden, beispielsweise kann das Verhältnis von verwendetem maximalem Teilerwert zu minimalem Teilerwert reduziert werden. Aufgrund des reduzierten Verhältnisses kann ein benötigter Betriebsbereich des einstellbaren Teilers verkleinert werden und somit beispielsweise eine Variation der Schleifenverstärkung verringert werden und/oder der Einsatz der gemeinsamen Phasenregelschleife zur Verarbeitung des breitbandigen Frequenzsignals als Rückkoppelsignal ermöglicht werden.

Beispielswiese weist die Vorrichtung mit Mischer im Rückkoppelpfad der gemeinsamen Phasenregelschleife einen zweiten gesteuerten Oszillator und einen weiteren Mischer auf, der ausgebildet ist, durch Mischen eines Ausgangssignals des ersten gesteuerten Oszillators und eines Ausgangssignals des zweiten gesteuerten Oszillators das Frequenzsignal zu erzeugen. Der Ausgang des weiteren Mischers kann mit der gemeinsamen Phasenregelschleife gekoppelt sein. Das erzeugte Frequenzsignal kann als Steuersignal in die Phasenregelschleife rückgekoppelt werden.

Ein Aspekt der vorliegenden Offenbarung betrifft eine Hochfrequenzvorrichtung, z.B. ein Hochfrequenzgerät, zum Erzeugen eines Hochfrequenzsignals mit einem Ausfiihrugsbeispiel der zuvor beschriebenen Vorrichtung. Beispielsweise kann die Vorrichtung in verschiedenen Anwendungen eingesetzt werden, in denen sehr breitbandige Signale generiert werden und bei denen beispielsweise die Verlustleistung, Schaltungsaufwand und/oder die Störfestigkeit gegenüber Störeinkopplungen eine Rolle spielt. Beispiele sind etwa Hochfrequenz-Messtechnik, Radartechnik und Mobilkommunikation. Entsprechend kann die Hochfrequenzvorrichtung als Messvorrichtung, Radarvorrichtung oder Mobilfunkvorrichtung (z.B. Kommunikations-Chip) ausgebildet sein.

Ein Ausführungsbeispiel eines Verfahrens zum Erzeugen eines breitbandigen umfasst ein Betreiben eines ersten gesteuerten Oszillators und eines zweiten gesteuerten Oszillators unter Verwendung einer gemeinsamen Phasenregelschleife und basierend auf einem Spannungssignal, welches durch die gemeinsame Phasenregelschleife basierend auf einem breitbandige Frequenzsignal erzeugt wird. Der erste und der zweite gesteuerte Oszillator bewirken bei einer Änderung des Spannungssignals eine gegenläufige Frequenzveränderung. Das Verfahren umfasst ferner ein Mischen von Ausgangssignalen der beiden gesteuerten Oszillatoren, um das breitbandige Frequenzsignal zu erzeugen.

Beispielsweise kann in effizienter Weise ein breitbandiges Frequenzsignal mit erhöhter Bandbreite aus den Ausgangssignalen der beiden gesteuerten Oszillatoren (z.B. breitbandige Oszillatoren mit einer absoluten Bandbreite von 20 GHz) erzeugt werden, wobei lediglich eine einzige Phasenregelschleife benötigt wird. Dadurch kann ein Schaltungsaufwand einer Schaltung zum Ausführen des Verfahrens deutlich reduziert werden.

Beispielsweise weist die verfahrensmäßig verwendete Phasenregelschleife in einem Rückkoppelpfad zwischen Ausgang eines Mischers und Eingang eines Phasen-Frequenz-Diskriminators einen einstellbaren Frequenzteiler (fractional divider) auf. Beim Betreiben der Phasenregelschleife kann ein Verhältnis eines maximalen Teilerwertes des einstellbaren Teilers zu einem minimalen Teilerwert des einstellbaren Teilers mit einem Wert von weniger als 3 (oder von weniger als 2, oder von weniger als 1,5) verwendet werden. Dies kann dadurch erreicht werden, dass ein Rückkoppelsignal in dem Rückkoppelpfad der Phasenregelschleife beispielsweise vor dem Verarbeiten mittels des einstellbaren Teilers auf eine höhere Frequenz gemischt wird, sodass ein relativer Unterschied zwischen einer maximalen und einer minimalen Frequenz des am Teiler anliegenden Signals minimiert werden kann. Durch das geringere Verhältnis der verwendeten Teilerwerte kann etwa eine Variation einer Schleifenverstärkung der Phasenregelschleife reduziert werden.

Beispielsweise kann verfahrensgemäß eine Frequenzrampe (und/oder ein monofrequentes Signal und/oder ein Signal mit Frequenzumtastung oder Frequenzsprüngen) mit einer relativen Bandbreite von zumindest 20 % erzeugt werden. Beispielsweise können Radarsignale oder Mobilfunksignale erzeugt oder generiert werden.

Beispiele, die in Verbindung mit der vorgeschlagenen Vorrichtung genannt wurden können auch für das vorgeschlagene Hochfrequenzgerät und/oder das vorgeschlagene Verfahren genutzt werden. Daher wird auf eine wiederholende Beschreibung dieser Beispiele verzichtet. In Verbindung mit der Vorrichtung beschriebene Beispiele gelten auch in Verbindung mit dem Hochfrequenzgerät und dem vorgeschlagenen Verfahren als offenbart.

**Figurenkurzbeschreibung**

Einige Beispiele von Vorrichtungen und/oder Verfahren werden nachfolgend bezugnehmend auf die beiliegenden Figuren lediglich beispielhaft näher erläutert. Es zeigen:

Fig. 1 eine schematische Darstellung einer nicht erfindungsgemäßen Vorrichtung mit zwei gesteuerten Oszillatoren;

Fig. 1a eine schematische Darstellung eines Ausführungsbeispiels einer Vorrichtung mit zwei gesteuerten Oszillatoren und einer gemeinsamen Phasenregelschleife;

Fig. 2 eine schematische Darstellung einer nicht erfindungsgemäßen Vorrichtung mit einem gesteuerten Oszillator in einem Rückkoppelpfad einer Phasenregelschleife;

Fig. 3 ein Flussdiagramm eines erfindungsgemäßen Vefahren und einer nicht erfindungsgemäßen Alternative zum Erzeugen eines breitbandigen Frequenzsignals;

Fig. 4 eine schematische Darstellung einer nicht erfindungsgemäßen Vorrichtung mit zwei gesteuerten Oszillatoren und jeweilige den Oszillatoren zugeordnete Phasenregelschleifen;

Fig. 5 eine schematische Darstellung einer erfindungsgemäßen Vorrichtung mit zwei gesteuerten Oszillatoren und einer gemeinsamen Phasenregelschleife;

Fig. 6 eine schematische Darstellung einer erfindungsgemäßen Vorrichtung mit verbesserter Unterdrückung von Störeinkopplungen;

Fig. 7 eine schematische Darstellung einer erfindungsgemäßen Vorrichtung mit einer differentiellen Ladungspumpe mit verbesserter Unterdrückung von Störeinkopplungen; und

Fig. 8 eine schematische Darstellung einer erfindungsgemäßen Vorrichtung mit zwei gesteuerten Oszillatoren und einem weiteren gesteuerten Oszillator mit Mischer in einem Rückkoppelpfad einer gemeinsamen Phasenregelschleife der zwei gesteuerten Oszillatoren.

**Beschreibung**

Verschiedene Beispiele werden nun ausführlicher Bezug nehmend auf die beiliegenden Figuren beschrieben, in denen einige Beispiele dargestellt sind. In den Figuren können die Stärken von Linien, Schichten und/oder Bereichen zur Verdeutlichung übertrieben sein.

Während sich weitere Beispiele für verschiedene Modifikationen und alternative Formen eignen, sind dementsprechend einige bestimmte Beispiele derselben in den Figuren gezeigt und werden nachfolgend ausführlich beschrieben. Allerdings beschränkt diese detaillierte Beschreibung weitere Beispiele nicht auf die beschriebenen bestimmten Formen. Weitere Beispiele können alle Modifikationen, Entsprechungen und Alternativen abdecken, die in den Rahmen der Offenbarung fallen. Gleiche oder ähnliche Bezugszeichen beziehen sich in der gesamten Beschreibung der Figuren auf gleiche oder ähnliche Elemente, die bei einem Vergleich miteinander identisch oder in modifizierter Form implementiert sein können, während sie die gleiche oder eine ähnliche Funktion bereitstellen.

Es versteht sich, dass, wenn ein Element als mit einem anderen Element "verbunden" oder "gekoppelt" bezeichnet wird, die Elemente direkt, oder über ein oder mehrere Zwischenelemente, verbunden oder gekoppelt sein können. Wenn zwei Elemente A und B unter Verwendung eines "oder" kombiniert werden, ist dies so zu verstehen, dass alle möglichen Kombinationen offenbart sind, d. h. nur A, nur B sowie A und B, sofern nicht explizit oder implizit anders definiert. Eine alternative Formulierung für die gleichen Kombinationen ist "zumindest eines von A und B" oder "A und/oder B". Das Gleiche gilt, mutatis mutandis, für Kombinationen von mehr als zwei Elementen.

Die Terminologie, die hier zum Beschreiben bestimmter Beispiele verwendet wird, soll nicht begrenzend für weitere Beispiele sein. Wenn eine Singularform, z. B. "ein, eine" und "der, die, das" verwendet wird und die Verwendung nur eines einzelnen Elements weder explizit noch implizit als verpflichtend definiert ist, können weitere Beispiele auch Pluralelemente verwenden, um die gleiche Funktion zu implementieren. Wenn eine Funktion nachfolgend als unter Verwendung mehrerer Elemente implementiert beschrieben ist, können weitere Beispiele die gleiche Funktion unter Verwendung eines einzelnen Elements oder einer einzelnen Verarbeitungsentität implementieren. Es versteht sich weiterhin, dass die Begriffe "umfasst", "umfassend", "aufweist" und/oder "aufweisend" bei Gebrauch das Vorhandensein der angegebenen Merkmale, Ganzzahlen, Schritte, Operationen, Prozesse, Elemente, Komponenten und/oder einer Gruppe derselben präzisieren, aber nicht das Vorhandensein oder das Hinzufügen eines oder mehrerer anderer Merkmale, Ganzzahlen, Schritte, Operationen, Prozesse, Elemente, Komponenten und/einer Gruppe derselben ausschließen.

Sofern nicht anderweitig definiert, werden alle Begriffe (einschließlich technischer und wissenschaftlicher Begriffe) hier in ihrer üblichen Bedeutung auf dem Gebiet verwendet, zu dem Beispiele gehören.

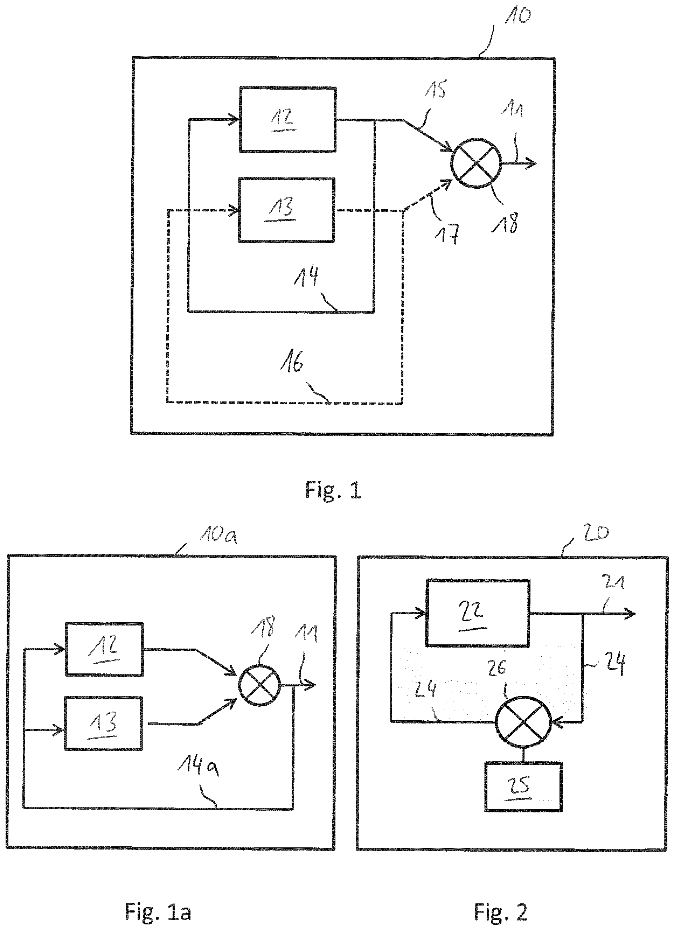

Fig. 1 zeigt eine schematische Darstellung einer nicht erfindungsgemäßen Vorrichtung 10 mit zwei gesteuerten Oszillatoren 12, 13. Die Vorrichtung 10 ist zum Erzeugen eines breitbandigen Frequenzsignals 11 (z.B. eines Ausgangssignals $f_{out}$) ausgebildet. Eine Phasenregelschleife 14 der Vorrichtung 10 ist zum Rückkoppeln eines Signals der Vorrichtung 10, das auf zumindest einem Ausgangssignal 15, 17 eines der gesteuerten Oszillatoren 12, 13 basiert, an den entsprechenden gesteuerten Oszillator 12, 13 ausgebildet. Beispielsweise wird das Ausgangssignal 15 des ersten gesteuerten Oszillators 12 über die Phasenregelschleife 14 an den Eingang des Oszillators 12 rückgekoppelt. Beispielsweise weist die Vorrichtung 10 eine weitere Phasenregelschleife 16 auf, über die das Ausgangssignal 17 des zweiten Oszillators 13 rückgekoppelt wird. Alternativ kann das breitbandige Frequenzsignal 11 über die Phasenregelschleife 14 sowohl an den Eingang des ersten Oszillators 12 als auch an den Eingang des zweiten Oszillators 13 geleitet werden. Die Phasenregelschleife 14 kann eine PLL-Schaltung, z.B. inkl. Teilern, PFD, CP, Referenzsignal, und/oder Schleifenfilter u.a.) darstellen.

Ferner umfasst die Vorrichtung 10 einen Mischer 18, der ausgebildet ist, durch Mischen des Ausgangssignals 15 des ersten gesteuerten Oszillators 12 und des Ausgangssignals 17 des zweiten gesteuerten Oszillators 13 das breitbandige Frequenzsignal 11 zu erzeugen. Durch das Mischen der beiden Ausgangssignale 15, 17 kann das breitbandige Frequenzsignal 11 mit erhöhter Bandbreite erzeugt werden, beispielsweise mit einer Bandbreite die der Summe der Bandbreiten der beiden Ausgangssignale 15, 17 entspricht.

Fig. 1a zeigt eine schematische Darstellung einer Vorrichtung 10a, ebenfalls mit zwei gesteuerten Oszillatoren 12, 13. Auch die Vorrichtung 10a ist zum Erzeugen eines breitbandigen Frequenzsignals 11 (z.B. des Ausgangssignals $f_{out}$) ausgebildet. Eine gemeinsame Phasenregelschleife 14a der Vorrichtung 10a ist zum Rückkoppeln des breitbandigen Frequenzsignals 11 der Vorrichtung 10a an beide Oszillatoren 12, 13 ausgebildet.

Fig. 2 zeigt eine schematische Darstellung einer nicht erfindungsgemäßen Vorrichtung 20 mit einem gesteuerten Oszillator 25 in einem Rückkoppelpfad einer Phasenregelschleife 24 der Vorrichtung 20. Die Vorrichtung 20 ist zum Erzeugen eines Frequenzsignals 21 ausgebildet und umfasst zumindest einen ersten gesteuerten Oszillator 22 sowie eine Phasenregelschleife 24 mit dem weiteren gesteuerten Oszillator 25 und einem Mischer 26 im Rückkoppelpfad der Phasenregelschleife 24. Dadurch kann eine Frequenz eines Rückkoppelsignals der Phasenregelschleife 24 mittels des weiteren gesteuerten Oszillators 25 und des Mischers 26 erhöht werden. Beispielsweise wird das auf eine höhere Frequenz hochgemischte rückgekoppelte Signal an einen weiteren Frequenzteiler vor einem Phasen-Frequenz-Diskriminator der Phasenregelschleife 24 weitergeleitet.

Die Erhöhung der Frequenz des rückgekoppelten Signals ermöglicht es beispielsweise einen relativen Frequenzbereich des Signals, das am weiteren Frequenzteiler (z.B. mit einstellbarem, gebrochenem Frequenzverhältnis) empfangen wird, zu reduzieren. Dadurch kann ein Verhältnis zwischen einem maximalen und einem minimalen Teilerwert des weiteren Frequenzteilers reduziert werden und somit z.B. eine Variation der Schleifenverstärkung der Phasenregelschleife 24 reduziert werden.

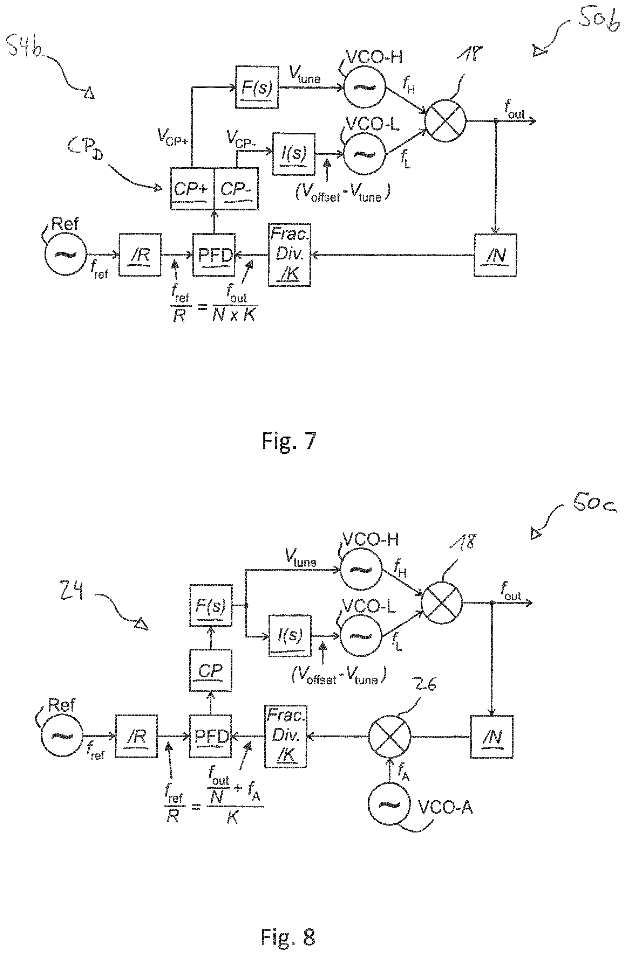

Weitere Details und Aspekte sind in Verbindung mit weiter oben oder weiter unten ausgeführten Beispielen beschrieben. Die anhand von Fig. 2 gezeigten Beispiele können eines oder mehrere optionale, zusätzliche Merkmale aufweisen, die zu einem oder mehreren Aspekten korrespondieren, die in Verbindung mit dem vorgeschlagenen Konzept oder ein oder mehreren Beispielen weiter oben oder weiter unten beschrieben sind (zum Beispiel in Verbindung mit Fig. 1 und 3-7, insbesondere in Verbindung mit Fig. 8).

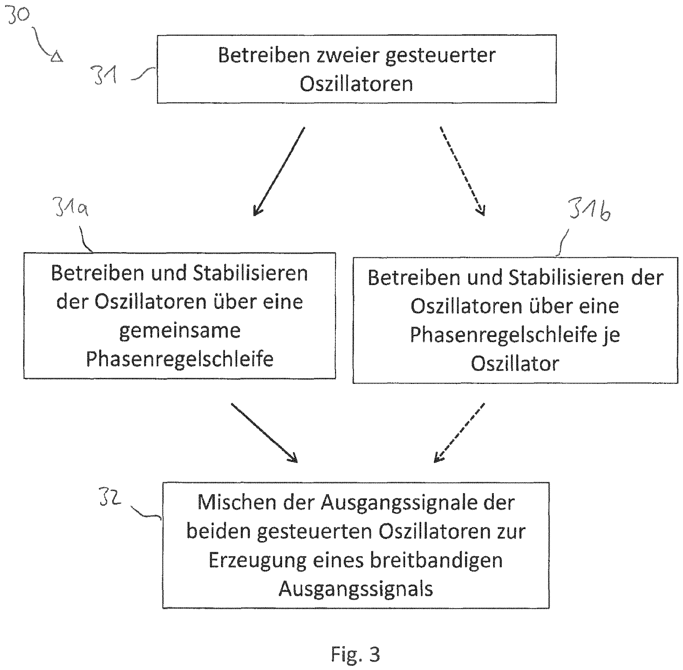

Fig. 3 zeigt ein Flussdiagramm eines Verfahrens 30 zum Erzeugen eines breitbandigen Frequenzsignals. Das Verfahren 30 umfasst ein Betreiben 31 eines ersten gesteuerten Oszillators und eines zweiten gesteuerten Oszillators unter Verwendung einer gemeinsamen Phasenregelschleife (z.B. Betreiben und Stabilisieren 31a der Oszillatoren über eine gemeinsame Phasenregelschleife) und ein Mischen 32 der Ausgangssignale der beiden gesteuerten Oszillatoren, um das breitbandige Frequenzsignal zu erzeugen.

Alternativ und nicht erfindungsgemäß ist ein Verfahren dargestellt, das ein Betreiben und Stabilisieren 31b der Oszillatoren über eine Phasenregelschleife je Oszillator umfasst. Auch im alternativen Verfahren erfolgt ein Mischen 32 der Ausgangssignale der beiden gesteuerten Oszillatoren zur Erzeugung des breitbandigen Ausgangssignals.

Weitere Details und Aspekte sind in Verbindung mit weiter oben oder weiter unten ausgeführten Beispielen beschrieben. Die anhand von Fig. 3 gezeigten Beispiele können eines oder mehrere optionale, zusätzliche Merkmale aufweisen, die zu einem oder mehreren Aspekten korrespondieren, die in Verbindung mit dem vorgeschlagenen Konzept oder ein oder mehreren Beispielen weiter oben oder weiter unten beschrieben sind (zum Beispiel in Verbindung mit Fig. 1, 2 und 4-8).

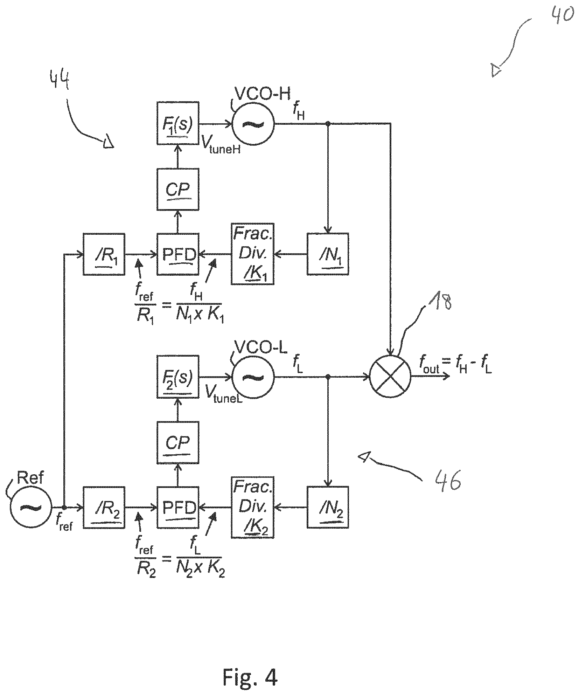

Fig. 4 zeigt eine schematische Darstellung einer nicht erfindungsgemäßen Vorrichtung 40 mit zwei gesteuerten Oszillatoren (hier spannungsgesteuerte Oszillatoren, VCO) VCO-H, VCO-L und einer Phasenregelschleife 44, 46 je Oszillator VCO-H, VCO-L. Beispielsweise ist ein Frequenzbereich des einen gesteuerten Oszillators VCO-H höher als der des anderen gesteuerten Oszillators VCO-L. Ein Mischer 18 ist ausgebildet, um Ausgangssignale $f_H$, $f_L$ der Oszillatoren VCO-H, VCO-L zu einem Ausgangssignal $f_{out}$ der Vorrichtung 40 zu mischen.

In der jeweiligen Phasenregelschleife 44, 46 wird ein jeweiliges Ausgangssignal $f_H$, $f_L$ des entsprechenden Oszillatoren VCO-H, VCO-L je durch einen ersten statischen Frequenzteiler $/N_1$, $/N_2$ (integer divider; ganzzahliger Teiler) und einen einstellbaren Teiler $/K_1$, $/K_2$ (fractional und/oder integer divider; einstellbarer Teiler mit ganzzahligem und/oder gebrochenen Teilverhältnissen) geteilt und mit einem durch jeweilige Teiler $/R_1$, $/R_2$ geteilten Referenzsignal $f_{Ref}$ einer Referenzsignalquelle Ref über je einen separaten Phasen-Frequenz-Diskriminator PFD verglichen. Eine Phasendifferenz, die der PFD ausgibt, dient als Regelgröße und wird über je eine Ladungspumpe CP (engl.: CP: Charge Pump) und einen Schleifenfilter Fi(s), $F_2(s)$ in eine Regelspannung umgewandelt, die die Ausgangsfrequenz des jeweiligen Oszillators VCO-H, VCO-L so einstellt, dass die Phasendifferenz der beiden Eingangsfrequenzen am entsprechenden PFD gleich null ist.

Beispielsweise decken die hochfrequenten Oszillatoren zwei aneinander angrenzende Frequenzbereiche ab (bspw. 80 GHz -100 GHz für VCO-L und 100 GHz - 120 GHz für VCO-H), sodass hinter dem Mischer Ausgangssignale erzeugt werden können, die die kombinierte Bandbreite beider VCOs besitzen (bspw. von 0 Hz - 40 GHz).

Weitere Details und Aspekte sind in Verbindung mit weiter oben oder weiter unten ausgeführten Beispielen beschrieben. Die anhand von Fig. 4 gezeigten Beispiele können eines oder mehrere optionale, zusätzliche Merkmale aufweisen, die zu einem oder mehreren Aspekten korrespondieren, die in Verbindung mit dem vorgeschlagenen Konzept oder ein oder mehreren Beispielen weiter oben oder weiter unten beschrieben sind (zum Beispiel in Verbindung mit Fig. 1-3 und 5-8).

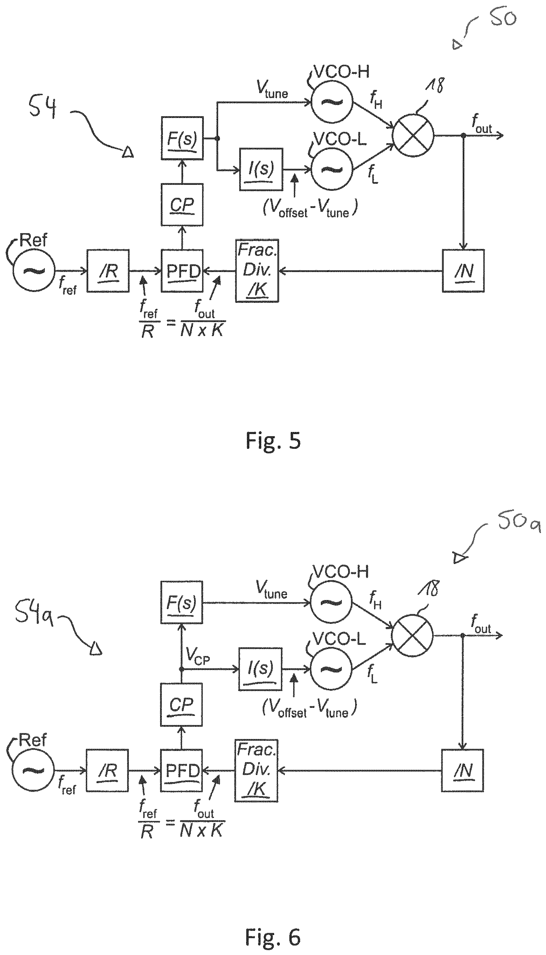

Fig. 5 zeigt eine schematische Darstellung einer Vorrichtung 50 mit zwei gesteuerten Oszillatoren VCO-H, VCO-L und einer gemeinsamen Phasenregelschleife 54. Die Phasenregelschleife 54 umfasst einen ganzzahligen Teiler $/N$ und einen gebrochen-zahligen und/oder ganzzahligen (fractional und/oder integer divider ) einstellbaren Teiler $/K$, über die das Ausgangssignal $f_{out}$ der Vorrichtung 50 an einen gemeinsamen Phasen-Frequenz-Diskriminator PFD geleitet wird. Ein Referenzsignal $f_{Ref}$ einer Referenzsignalquelle Ref wird über einen Teiler $/R$ an den Phasen-Frequenz-Diskriminator PFD geleitet. Eine Phasendifferenz, die der PFD ausgibt, dient als Regelgröße und wird über eine gemeinsame Ladungspumpe CP und einen Schleifenfilter F(s) in eine Regelspannung $V_{tune}$ umgewandelt.

Die Regelspannung $V_{tune}$ wird direkt als Eingangssignal des ersten spannungsgesteuerten Oszillators VCO-H genutzt. Ferner ist ein zusätzlicher Filter I(s) (z.B. invertierend, z.B. Subtrahierverstärker) vorgesehen, welcher das Steuersignal oder die Regelspannung $V_{tune}$ verarbeitet und auf den Arbeitsbereich des zweiten spannungsgesteuerten Oszillators derart anpasst, dass dieser seinen gesamten Arbeitsbereich gegenläufig zu dem des ersten spannungsgesteuerten Oszillators durchläuft. Z.B. wird ein Ausgangssignal $V_{offset}$-$V_{tune}$ des zusätzlichen Filters I(s) als Eingangssignal des zweiten spannungsgesteuerten Oszillators VCO-L genutzt. Somit führt beispielsweise eine Erhöhung der Regelspannung $V_{tune}$ zu einer Frequenzerhöhung des Signals in des ersten Oszillators VCO-H und gleichzeitig zu einer Frequenzverringerung des Signals $f_L$ des zweiten Oszillators VCO-L. Dadurch kann mit einem gemeinsamen Steuersignal ein breitbandiges Frequenzsignal $f_{out}$ erzeugt werden.

Dabei verhält sich die Schaltung umfassend beide VCOs, I(s) und Mischer z.B. wie ein einzelner Oszillator, der aus einer Stellgröße hinter F(s), eine Ausgangsspannung $f_{out}$ erzeugt. Das durch die Teiler /N und /K heruntergeteilte Signal $f_{out}$ wird von der PLL 54 durch den PFD mit der durch den Teiler /R geteilten Referenzfrequenz verglichen und der Phasenfehler über CP und F(s) zur Erzeugung der Stellgröße $V_{tune}$ verwendet.

Weitere Details und Aspekte sind in Verbindung mit weiter oben oder weiter unten ausgeführten Beispielen beschrieben. Die anhand von Fig. 5 gezeigten Beispiele können eines oder mehrere optionale, zusätzliche Merkmale aufweisen, die zu einem oder mehreren Aspekten korrespondieren, die in Verbindung mit dem vorgeschlagenen Konzept oder ein oder mehreren Beispielen weiter oben oder weiter unten beschrieben sind (zum Beispiel in Verbindung mit Fig. 1-4 und 6-8).

Fig. 6 zeigt eine schematische Darstellung einer Vorrichtung 50a mit verbesserter Unterdrückung von Störeinkopplungen. Im Gegensatz zu der in Fig. 5 gezeigten Vorrichtung 50 weist eine Phasenregelschleife 54a der Vorrichtung 50a zwei separate Schleifenfilter F(s), I(s) auf, die aus einem Ausgangssignal $V_{CP}$ der Ladungspumpe CP jeweils ein Steuersignal für die Oszillatoren erzeugen. Das vom Schleifenfilter F(s) erzeugte Signal $V_{tune}$ wird als Eingangssignal für den ersten Oszillator VCO-H genutzt und das vom Schleifenfilter I(s) erzeugte Signal $V_{offset}$-$V_{tune}$ wird als Eingangssignal für den zweiten Oszillator VCO-L genutzt.

Beispielsweise sind Signalleitungen der Vorrichtung 50a zwischen Ladungspumpe CP und Schleifenfiltern F(s), I(s) sehr kurz gehalten, um den Einfluss von Störeinkopplungen zu reduzieren. Die hinter den Schleifenfiltern liegenden Tunespannungen können als differentielles Regelsignalpaar bezeichnet werden, bei denen Störeinkopplungen durch den Mischprozess der Signale der beiden VCOs reduziert oder eliminiert werden.

Weitere Details und Aspekte sind in Verbindung mit weiter oben oder weiter unten ausgeführten Beispielen beschrieben. Die anhand von Fig. 6 gezeigten Beispiele können eines oder mehrere optionale, zusätzliche Merkmale aufweisen, die zu einem oder mehreren Aspekten korrespondieren, die in Verbindung mit dem vorgeschlagenen Konzept oder ein oder mehreren Beispielen weiter oben oder weiter unten beschrieben sind (zum Beispiel in Verbindung mit Fig. 1-5 und 7-8).

Fig. 7 zeigt eine schematische Darstellung einer Vorrichtung 50b mit einer Phasenregelschleife 54b mit einer differentiellen Ladungspumpe $CP_D$. Die differentielle Ladungspumpe $CP_D$ ist ausgebildet, um differentielle Ausgangsspannungen zu erzeugen. Ein erster Teil CP+ der differentiellen Ladungspumpe $CP_D$ ist ausgebildet, um ein positives Signal $V_{CP+}$ an den ersten Schleifenfilter F(s) zu übertragen. Ein zweiter Teil CP- der differentiellen Ladungspumpe $CP_D$ ist ausgebildet, um ein negatives Signal $V_{CP-}$ an den zweiten Schleifenfilter I(s) zu übertragen. Dadurch kann es ermöglicht werden, Gleichtaktstöreinkopplungen auf die Spannungssignale $V_{CP+}$ und $V_{CP-}$ oder $V_{tune}$ und $V_{offset}$-$V_{tune}$ aufgrund des differentiellen Designs der Vorrichtung 50b durch den Mischprozess im Mischer 18 stärker zu kompensieren.

Weitere Details und Aspekte sind in Verbindung mit weiter oben oder weiter unten ausgeführten Beispielen beschrieben. Die anhand von Fig. 7 gezeigten Beispiele können eines oder mehrere optionale, zusätzliche Merkmale aufweisen, die zu einem oder mehreren Aspekten korrespondieren, die in Verbindung mit dem vorgeschlagenen Konzept oder ein oder mehreren Beispielen weiter oben oder weiter unten beschrieben sind (zum Beispiel in Verbindung mit Fig. 1-6 und 8).

Fig. 8 zeigt eine schematische Darstellung einer Vorrichtung 50c mit zwei gesteuerten Oszillatoren VCO-H, VCO-L und einem zusätzlichen spannungsgesteuerten Oszillator VCO-A sowie einem zusätzlichen Mischer 26 in einem Rückkoppelpfad einer gemeinsamen Phasenregelschleife 24 der zwei gesteuerten Oszillatoren VCO-H, VCO-L.

Die Erweiterung durch den spannungsgesteuerten Oszillator VCO-A sowie den zusätzlichen Mischer 26 in Vorrichtung 50c ermöglicht das Hochmischen des durch den Teiler /N geteilten Ausgangssignals $f_{out}$ mit einer Frequenz $f_A$ des zusätzlichen Oszillators VCO-A. Dies kann eine Reduktion einer Variation der Schleifenverstärkung ermöglichen, etwa um zu ermöglichen, dass die PLL 24 in der Lage ist, die maximale Bandbreite von $f_{out}$ zu stabilisieren. Da der Teiler /N konstant ist, hängt die Variation der Schleifenverstärkung z.B. überwiegend von der Übertragungsfunktion der Oszillatoren VCO-H, VCO-L und vom einstellbaren Teiler /K ab. Durch das Hochmischen des durch Teiler /N geteilten Signals mit der Frequenz $f_A$ in Richtung des oberen Frequenzbereichs, den die PLL 24 an ihrem Eingang (vor dem Teiler /K) im Normalbetrieb verarbeiten kann, kann die Variation der Schleifenverstärkung durch ein kleineres Verhältnis von minimalem Wert $K_{min}$ und maximalem Wert $K_{max}$ des Teilers /K reduziert werden.

Beispielsweise würde für eine Vorrichtung ohne zusätzlichen Oszillator VCO-A mit $\frac{f_{out}}{N} = 1 \ldots 3 \ GHz$ und $\frac{f_{ref}}{R} = 100 \ MHz$ für minimalen und maximalen am einstellbaren Teiler verwendete Werte Kmin, $K_{max}$ gelten:

$$K_{min} = \frac{1 \ GHz}{100 \ MHz} = 10; \ K_{max} = \frac{3 \ GHz}{100 \ MHz} = 30$$

. Somit wäre ein Verhältnis von $K_{max}/K_{min} = 3$ erreicht. Im Gegensatz dazu kann mittels des zusätzlichen Oszillators VCO-A die durch den Teiler /N geteilte Frequenz des Ausgangs-

signals $f_{out}$ erhöht werden, beispielsweise um die Frequenz $f_A$ mit einem Wert von $f_A$ = 5 GHz. Mit $f_A$ = 5 $GHz$ sowie

$$\frac{f_{out}}{N} + f_A = 6 \dots 8\ GHz$$ und $$\frac{f_{ref}}{R} = 100\ MHz$$ folgt für $$K_{min} = \frac{6\ GHz}{100\ MHz} = 60$$ und für

$$K_{max} = \frac{8\ GHz}{100\ MHz} = 80$$ . Dies führt zu einem reduzierten Verhältnis von $\frac{K_{max}}{K_{min}} = 1,\overline{3}$ . Dadurch, dass die Phasenregelschleife in einem kleineren Betriebsbereich der Teilverhältnisse des einstellbaren Teilers /K betrieben wird, kann eine auftretende Variation der Schleifenverstärkung im Betrieb reduziert werden.

Beispielsweise lässt sich durch die Verwendung höherer Teiler /N das Verhältnis $\frac{K_{max}}{K_{min}}$ für den Betrieb des Teilers /K weiter reduzieren. Beispielsweise lässt sich auch ohne zusätzlichen VCO-A die Variation von Werten des Teilers /K durch höhere Teiler /N reduzieren, allerdings können einige PLLs Teilerwerte des Teilers /K > 1 erfordern. Daher kann es vorteilhaft sein, die Eingangsfrequenzen der PLL am Teilereingang /K am oberen Rand des Eingangsfrequenzbereichs, den die PLL nutzen kann, zu wählen.

Zudem ist das Konzept mit zusätzlichem Oszillator VCO-A und Mischer 26 mit einer Verschiebung der PLL-Regelfrequenz zu höheren Frequenzen z.B. auch auf PLL-Realisierungen mit einem einzigen VCO anwendbar (z.B. in einer Phasenregelschleife gemäß Fig. 4) und kann die Nutzung von kommerziellen oder bereits vorhandenen PLL-Bausteinen ermöglichen, die beispielsweise einen minimalen Teiler /K von ungleich 1 aufweisen (z.B. >30), welche z.B. nicht beliebig kleine Eingangsfrequenzen verarbeiten können. Durch diesen minimalen Teiler /K ist es für eine PLL nicht möglich, niedrige Frequenzen (z.B. $\frac{f_{out}}{N \times K} < \frac{f_{ref}}{R}$ ) zu regeln, was bei den gezeigten Konzepten notwendig sein kann, da beispielsweise breitbandige Ausgangsfrequenzen des Signals $f_{out}$ zwischen 0 Hz bis zu mehreren 10 GHz erzeugt werden sollen.

Die Nutzung des zusätzlichen Mischers lässt sich, wie erwähnt, nicht nur auf das in Fig. 8 gezeigte Signalerzeugungsprinzip mit zwei VCOs, sondern auch auf für beliebige Signalerzeugungsschaltungen mit gesteuertem Oszillator und Phasenregelschleife (z.B. ein Oszillator mit einer diesem exklusiv zugeordneten Phasenregelschleife) anwenden.

Weitere Details und Aspekte sind in Verbindung mit weiter oben oder weiter unten ausgeführten Beispielen beschrieben. Die anhand von Fig. 8 gezeigten Beispiele können eines oder mehrere optionale, zusätzliche Merkmale aufweisen, die zu einem oder mehreren Aspekten korrespondieren, die in Verbindung mit dem vorgeschlagenen Konzept oder ein oder mehreren Beispielen weiter oben oder weiter unten beschrieben sind (zum Beispiel in Verbindung mit Fig. 1-7).

Ein Aspekt der Offenbarung betrifft ein Verfahren zur Stabilisierung zweier Oszillatoren mit einem einzigen Phasenregelkreis (PLL) zur Erzeugung breitbandiger Signale.

Durch die vorgeschlagenen Konzepte lassen sich beispielsweise durch zwei sehr hochfrequente VCOs in einfacher Weise breitbandige Ausgangssignale erzeugen, wobei z.B. nur eine PLL benötigt wird, sodass verglichen mit anderen Konzepten der Schaltungsaufwand und die Verlustleistung reduziert werden können. Zum Beispiel lässt sich die Robustheit der Signalerzeugung gegenüber Störeinkopplungen durch die vorgeschlagenen differentiellen Tune-Spannungen (z.B. Steuerspannungen der gesteuerten Oszillatoren) verbessern. Ferner kann das In-Loop-Phasenrauschen durch die Regelung einer gemeinsamen Phasenregelschleife mit $f_{out}$ reduziert werden.

Die Aspekte und Merkmale, die zusammen mit einem oder mehreren der vorher detaillierten Beispiele und Figuren beschrieben sind, können auch mit einem oder mehreren der anderen Beispiele kombiniert werden, um ein gleiches Merkmal des anderen Beispiels zu ersetzen oder um das Merkmal in das andere Beispiel zusätzlich einzuführen.

Beispiele können weiterhin ein Computerprogramm mit einem Programmcode zum Ausführen eines oder mehrerer der obigen Verfahren sein oder sich darauf beziehen, wenn das Computerprogramm auf einem Computer oder Prozessor ausgeführt wird. Schritte, Operationen oder Prozesse von verschiedenen, oben beschriebenen Verfahren können durch programmierte Computer oder Prozessoren ausgeführt werden. Beispiele können auch Programmspeichervorrichtungen, z. B. Digitaldatenspeichermedien, abdecken, die maschinen-, prozessor- oder computerlesbar sind und maschinenausführbare, prozessorausführbare oder computerausführbare Programme von Anweisungen codieren. Die Anweisungen führen einige oder alle der Schritte der oben beschriebenen Verfahren aus oder verursachen deren Ausführung. Die Programmspeichervorrichtungen können z. B. Digitalspeicher, magnetische Speichermedien wie beispielsweise Magnetplatten und Magnetbänder, Festplattenlaufwerke oder optisch lesbare Digitaldatenspeichermedien umfassen oder sein. Weitere Beispiele können auch Computer, Prozessoren oder Steuereinheiten, die zum Ausführen der Schritte der oben beschriebenen Verfahren programmiert sind, oder (feld-)programmierbare Logik-Arrays ((F)PLAs = (Field) Programmable Logic Arrays) oder (feld- )programmierbare Gate-Arrays ((F)PGA = (Field) Programmable Gate Arrays), die zum Ausführen der Schritte der oben beschriebenen Verfahren programmiert sind, abdecken.

Durch die Beschreibung und Zeichnungen werden nur die Grundsätze der Offenbarung dargestellt. Weiterhin sollen alle hier aufgeführten Beispiele grundsätzlich ausdrücklich nur illustrativen Zwecken dienen, um den Leser beim Verständnis der Grundsätze der Offenbarung und der durch den (die) Erfinder beigetragenen Konzepte zur Weiterentwicklung der Technik zu unterstützen. Alle hiesigen Aussagen über Grundsätze, Aspekte und Beispiele der Offenbarung sowie konkrete Beispiele derselben umfassen deren Entsprechungen.

Ein als "Mittel zum..." Ausführen einer bestimmten Funktion bezeichneter Funktionsblock kann sich auf eine Schaltung beziehen, die ausgebildet ist zum Ausführen einer bestimmten Funktion. Somit kann ein "Mittel für etwas" als ein "Mittel ausgebildet für oder geeignet für etwas" implementiert sein, z. B. ein Bauelement oder eine Schaltung ausgebildet für oder geeignet für die jeweilige Aufgabe.

Funktionen verschiedener in den Figuren gezeigter Elemente einschließlich jeder als "Mittel", "Mittel zum Bereitstellen eines Signals", "Mittel zum Erzeugen eines Signals", etc. bezeichneter Funktionsblöcke kann in Form dedizierter Hardware, z. B "eines Signalanbieters", "einer Signalverarbeitungseinheit", "eines Prozessors", "einer Steuerung" etc. sowie als Hardware fähig zum Ausführen von Software in Verbindung mit zugehöriger Software implementiert sein. Bei Bereitstellung durch einen Prozessor können die Funktionen durch einen einzelnen dedizierten Prozessor, durch einen einzelnen gemeinschaftlich verwendeten Prozessor oder durch eine Mehrzahl von individuellen Prozessoren bereitgestellt sein, von denen einige oder von denen alle gemeinschaftlich verwendet werden können. Allerdings ist der Begriff "Prozessor" oder "Steuerung" bei Weitem nicht auf ausschließlich zur Ausführung von Software fähige Hardware begrenzt, sondern kann Digitalsignalprozessor-Hardware (DSP-Hardware; DSP = Digital Signal Processor), Netzprozessor, anwendungsspezifische integrierte Schaltung (ASIC = Application Specific Integrated Circuit), feldprogrammierbare Logikanordnung (FPGA = Field Programmable Gate Array), Nurlesespeicher (ROM = Read Only Memory) zum Speichern von Software, Direktzugriffsspeicher (RAM = Random Access Memory) und nichtflüchtige Speichervorrichtung (storage) umfassen. Sonstige Hardware, herkömmliche und/oder kundenspezifische, kann auch eingeschlossen sein.

Ein Blockdiagramm kann zum Beispiel ein grobes Schaltdiagramm darstellen, das die Grundsätze der Offenbarung implementiert. Auf ähnliche Weise können ein Flussdiagramm, ein Ablaufdiagramm, ein Zustandsübergangsdiagramm, ein Pseudocode und dergleichen verschiedene Prozesse, Operationen oder Schritte repräsentieren, die zum Beispiel im Wesentlichen in computerlesbarem Medium dargestellt und so durch einen Computer oder Prozessor ausgeführt werden, ungeachtet dessen, ob ein solcher Computer oder Prozessor explizit gezeigt ist. In der Beschreibung oder in den Patentansprüchen offenbarte Verfahren können durch ein Bauelement implementiert werden, das ein Mittel zum Ausführen eines jeden der jeweiligen Schritte dieser Verfahren aufweist.

Es versteht sich, dass die Offenbarung mehrerer, in der Beschreibung oder den Ansprüchen offenbarter Schritte, Prozesse, Operationen oder Funktionen nicht als in der bestimmten Reihenfolge befindlich ausgelegt werden soll, sofern dies nicht explizit oder implizit anderweitig, z. B. aus technischen Gründen, angegeben ist. Daher werden diese durch die Offenbarung von mehreren Schritten oder Funktionen nicht auf eine bestimmte Reihenfolge begrenzt, es sei denn, dass diese Schritte oder Funktionen aus technischen Gründen nicht austauschbar sind. Ferner kann bei einigen Beispielen ein einzelner Schritt, Funktion, Prozess oder Operation mehrere Teilschritte, -funktionen, -prozesse oder -operationen einschließen und/oder in dieselben aufgebrochen werden. Solche Teilschritte können eingeschlossen sein und Teil der Offenbarung dieses Einzelschritts sein, sofern sie nicht explizit ausgeschlossen sind.

Weiterhin sind die folgenden Ansprüche hiermit in die detaillierte Beschreibung aufgenommen, wo jeder Anspruch als getrenntes Beispiel für sich stehen kann.

## Patentansprüche

1. Eine Vorrichtung (10a, 50) zum Erzeugen eines breitbandigen Frequenzsignals (11, $f_{out}$), die Vorrichtung (10a, 50) umfassend:

   einen ersten gesteuerten Oszillator (12);
   einen zweiten gesteuerten Oszillator (13);
   eine gemeinsame Phasenregelschleife (14a, 54), wobei der erste gesteuerte Oszillator (12) und der zweite gesteuerte Oszillator (12, 13) in der gemeinsamen Phasenregelschleife (14a, 54) umfasst sind, und wobei der erste gesteuerte Oszillator (12) und der zweite gesteuerte Oszillator (12, 13) basierend auf einem Spannungssignal gesteuert werden;
   einen Mischer (18), der ausgebildet ist, durch Mischen eines Ausgangssignals ($f_H$) des ersten gesteuerten Oszillators (12) und eines Ausgangssignals ($f_L$) des zweiten gesteuerten Oszillators (13) das breitbandige Frequenzsignal (11, $f_{out}$) zu erzeugen;

   wobei der Mischer (18) in der gemeinsamen Phasenregelschleife umfasst ist;
   wobei der erste und der zweite gesteuerte Oszillator (12, 13) ausgebildet sind, bei einer Änderung des Spannungssignals eine gegenläufige Frequenzveränderung zu bewirken,

wobei der Ausgang des Mischers (18) mit einem Rückkoppelpfad der gemeinsamen Phasenregelschleife (14a, 54) gekoppelt ist, zum Rückkoppeln des breitbandigen Frequenzsignals (11, $f_{out}$) über die gemeinsame Phasenregelschleife (14a, 54) und wobei das Spannungssignal durch die gemeinsame Phasenregelschleife (14a, 54) basierend auf dem rückgekoppelten breitbandigen Frequenzsignal (11, $f_{out}$) erzeugt wird.

**2.** Die Vorrichtung (10a, 50) gemäß Anspruch 1, ferner umfassend
eine dem ersten und dem zweiten gesteuerten Oszillator (12, 13) gemeinsam zugeordnete Referenzsignalquelle (Ref).

**3.** Die Vorrichtung (10a, 50) gemäß Anspruch 1 oder 2, die gemeinsame Phasenregelschleife ferner umfassend
ein separates Schleifenfilter (F(s), I(s)) je gesteuertem Oszillator.

**4.** Die Vorrichtung (10a, 50) gemäß einem der vorhergehenden Ansprüche,
wobei die gemeinsame Phasenregelschleife (14a) ausgebildet ist, ein differentielles Tune-Spannungspaar für die Oszillatoren zu erzeugen.

**5.** Die Vorrichtung (10a, 50) gemäß einem der vorhergehenden Ansprüche, die gemeinsame Phasenregelschleife (14, 14a) ferner umfassend:
eine differentielle Ladungspumpe ($CP_D$), wobei ein positiver Ausgang der differentiellen Ladungspumpe ($CP_D$) an den ersten gesteuerten Oszillator und ein negativer Ausgang der differentiellen Ladungspumpe ($CP_D$) an den zweiten gesteuerten Oszillator gekoppelt ist.

**6.** Die Vorrichtung (10a, 50) gemäß einem der vorhergehenden Ansprüche, die gemeinsame Phasenregelschleife ferner umfassend
einen zusätzlichen gesteuerten Oszillator (25, VCO-A) und einen zusätzlichen Mischer (26) im Rückkoppelpfad der gemeinsame Phasenregelschleife (14, 24), um eine Frequenz eines Rückkoppelsignals der gemeinsame Phasenregelschleife (14, 24) mittels des zusätzlichen gesteuerten Oszillators (25, VCO-A) und des zusätzlichen Mischers (26) zu erhöhen.

**7.** Die Vorrichtung (10a, 50) gemäß einem der vorhergehenden Ansprüche,

wobei eine obere Grenzfrequenz des ersten gesteuerten Oszillators (12) größer oder gleich einer unteren Grenzfrequenz des zweiten gesteuerten Oszillators (13) ist, oder
wobei eine obere Grenzfrequenz des ersten gesteuerten Oszillators (12) kleiner ist als eine untere Grenzfrequenz des zweiten gesteuerten Oszillators (13), wobei der Frequenzunterschied zwischen der oberen Grenzfrequenz des ersten gesteuerten Oszillators (12) und der unteren Grenzfrequenz des zweiten gesteuerten Oszillators (13) einer unteren Grenzfrequenz des breitbandigen Frequenzsignals (11, $f_{out}$) entspricht.

**8.** Verfahren (30) zum Erzeugen eines breitbandigen Frequenzsignals (11, $f_{out}$), das Verfahren (30) umfassend:

Betreiben (31a) eines ersten gesteuerten Oszillators (12) und eines zweiten gesteuerten Oszillators (13) unter Verwendung einer gemeinsamen Phasenregelschleife (14a, 54) basierend auf einem Spannungssignal;
Mischen (32) der Ausgangssignale der beiden gesteuerten Oszillatoren (12, 13), um das breitbandige Frequenzsignal (11, $f_{out}$) zu erzeugen; und
Betreiben (31a) der Oszillatoren unter Verwendung der gemeinsamen Phasenregelschleife zum Rückkoppeln des breitbandigen Frequenzsignals (11, $f_{out}$), wobei das Spannungssignal durch die gemeinsame Phasenregelschleife (14a, 54) basierend auf dem rückgekoppelten breitbandige Frequenzsignal (11, $f_{out}$) erzeugt wird, und wobei der erste und der zweite gesteuerte Oszillator (12, 13) ausgebildet sind, bei einer Änderung einer Spannungssignals eine gegenläufige Frequenzveränderung zu bewirken.

**9.** Das Verfahren (30) gemäß Anspruch 8,
wobei beim Betreiben (31a) der Oszillatoren für die gemeinsame Phasenregelschleife (14a, 24) ein Verhältnis eines maximalen Teilerwertes eines einstellbaren Teilers (/K) der gemeinsamen Phasenregelschleife (14a, 54) zu einem minimalen Teilerwert des einstellbaren Teilers (/K) mit einem Wert von weniger als 5 verwendet wird.

**Claims**

1. An apparatus (10a, 50) for generating a broadband frequency signal (11, $f_{out}$), the apparatus (10a, 50) comprising:

   a first controlled oscillator (12);
   a second controlled oscillator (13);
   a common phase locked loop (14a, 54), wherein the first controlled oscillator (12) and the second controlled oscillator (12, 13) are included in the common phase locked loop (14a, 54), and wherein the first controlled oscillator (12) and the second controlled oscillator (12, 13) are controlled based on a voltage signal;
   a mixer (18) configured to generate the broadband frequency signal (11, $f_{out}$) by mixing an output signal ($f_H$) of the first controlled oscillator (12) and an output signal ($f_L$) of the second controlled oscillator (13);

   wherein the mixer (18) is included in the common phase-locked loop;
   wherein the first and second controlled oscillators (12, 13) are configured to cause an opposing frequency change when the voltage signal changes,

   wherein the output of the mixer (18) is coupled to a feedback path of the common phase locked loop (14a, 54) for feeding back the broadband frequency signal (11, $f_{out}$) through the common phase locked loop (14a, 54) and wherein the voltage signal is generated by the common phase locked loop (14a, 54) based on the fed back broadband frequency signal (11, $f_{out}$).

2. The apparatus (10a, 50) of claim 1, further comprising
   a reference signal source (Ref) commonly associated with the first and second controlled oscillators (12, 13).

3. The apparatus (10a, 50) of claim 1 or 2, the common phase-locked loop further comprising
   one separate loop filter (F(s), I(s)) per controlled oscillator.

4. The apparatus (10a, 50) of any one of the preceding claims,
   wherein the common phase locked loop (14a) is configured to generate a differential tune voltage pair for the oscillators.

5. The apparatus (10a, 50) of any one of the preceding claims, the common phase-locked loop (14, 14a) further comprising:
   a differential charge pump ($CP_D$), wherein a positive output of the differential charge pump ($CP_D$) is coupled to the first controlled oscillator and a negative output of the differential charge pump ($CP_D$) is coupled to the second controlled oscillator.

6. The apparatus (10a, 50) of any one of the preceding claims, the common phase-locked loop further comprising
   an additional controlled oscillator (25, VCO-A) and an additional mixer (26) in the feedback path of the common phase-locked loop (14, 24) to increase a frequency of a feedback signal of the common phase-locked loop (14, 24) by means of the additional controlled oscillator (25, VCO-A) and the additional mixer (26).

7. The apparatus (10a, 50) of any one of the preceding claims,

   wherein an upper cut-off frequency of the first controlled oscillator (12) is greater than or equal to a lower cut-off frequency of the second controlled oscillator (13), or
   wherein an upper cut-off frequency of the first controlled oscillator (12) is smaller than a lower cut-off frequency of the second controlled oscillator (13), wherein the frequency difference between the upper cut-off frequency of the first controlled oscillator (12) and the lower cut-off frequency of the second controlled oscillator (13) corresponds to a lower cut-off frequency of the broadband frequency signal (11, $f_{out}$).

8. A method (30) for generating a broadband frequency signal (11, $f_{out}$), the method (30) comprising:

   operating (31a) a first controlled oscillator (12) and a second controlled oscillator (13) using a common phase locked loop (14a, 54) based on a voltage signal;
   mixing (32) the output signals of the two controlled oscillators (12, 13) to generate the broadband frequency signal (11, $f_{out}$); and
   operating (31a) the oscillators using the common phase locked loop to feed back the broadband frequency

signal (11, $f_{out}$), wherein the voltage signal is generated by the common phase locked loop (14a, 54) based on the fed back broadband frequency signal (11, $f_{out}$), and

wherein the first and second controlled oscillators (12, 13) are configured to cause an opposing frequency change when a voltage signal is changed.

9. The method (30) of claim 8,
wherein, in operating (31a) the oscillators for the common phase-locked loop (14a, 24), a ratio of a maximum divider value of an adjustable divider (/K) of the common phase-locked loop (14a, 54) to a minimum divider value of the adjustable divider (/K) having a value of less than 5 is used.


**Revendications**

1. Dispositif (10a, 50) pour générer un signal de fréquence à large bande (11, $f_{out}$), le dispositif (10a, 50) comprenant :

    un premier oscillateur commandé (12) ;
    un deuxième oscillateur commandé (13) ;
    une boucle à verrouillage de phase commune (14a, 54), dans lequel le premier oscillateur commandé (12) et le deuxième oscillateur commandé (12, 13) sont inclus dans la boucle à verrouillage de phase commune (14a, 54), et dans lequel le premier oscillateur commandé (12) et le deuxième oscillateur commandé (12, 13) sont commandés sur la base d'un signal de tension ;
    un mélangeur (18) configuré pour générer le signal de fréquence à large bande (11, $f_{out}$) en mélangeant un signal de sortie ($f_H$) du premier oscillateur commandé (12) et un signal de sortie ($f_L$) du deuxième oscillateur commandé (13) ;

        dans lequel le mélangeur (18) est inclus dans la boucle à verrouillage de phase commune ;
        dans lequel le premier et le deuxième oscillateurs commandés (12, 13) sont configurés pour provoquer une variation de fréquence en sens inverse lors d'une modification du signal de tension,

dans lequel la sortie du mélangeur (18) est couplée à un chemin de rétroaction de la boucle à verrouillage de phase commune (14a, 54) pour rétroaction du signal de fréquence à large bande (11, $f_{out}$) par l'intermédiaire de la boucle à verrouillage de phase commune (14a, 54) et dans lequel le signal de tension est généré par la boucle à verrouillage de phase commune (14a, 54) sur la base du signal de fréquence à large bande rétroactionné (11, $f_{out}$).

2. Dispositif (10a, 50) selon la revendication 1, comprenant en outre
une source de signal de référence (Ref) associée en commun aux premier et deuxième oscillateurs commandés (12, 13).

3. Dispositif (10a, 50) selon la revendication 1 ou 2, la boucle à verrouillage de phase commune comprenant en outre un filtre de boucle séparé (F(s), I(s)) par oscillateur commandé.

4. Dispositif (10a, 50) selon l'une des revendications précédentes,
dans lequel la boucle à verrouillage de phase commune (14a) est configurée pour générer une paire de tensions d'accord différentielles pour les oscillateurs.

5. Dispositif (10a, 50) selon l'une des revendications précédentes, la boucle à verrouillage de phase commune (14, 14a) comprenant en outre :
une pompe de charge différentielle ($CP_D$), dans lequel une sortie positive de la pompe de charge différentielle ($CP_D$) est couplée au premier oscillateur commandé et une sortie négative de la pompe de charge différentielle ($CP_D$) est couplée au deuxième oscillateur commandé.

6. Dispositif (10a, 50) selon l'une des revendications précédentes, la boucle à verrouillage de phase commune comprenant en outre
un oscillateur commandé supplémentaire (25, VCO-A) et un mélangeur supplémentaire (26) dans le chemin de rétroaction de la boucle à verrouillage de phase commune (14, 24) pour augmenter une fréquence d'un signal de rétroaction de la boucle à verrouillage de phase commune (14, 24) au moyen de l'oscillateur commandé supplémentaire (25, VCO-A) et du mélangeur supplémentaire (26).

**7.** Dispositif (10a, 50) selon l'une des revendications précédentes,

dans lequel une fréquence de coupure supérieure du premier oscillateur commandé (12) est supérieure ou égale à une fréquence de coupure inférieure du deuxième oscillateur commandé (13), ou
dans lequel une fréquence de coupure supérieure du premier oscillateur commandé (12) est inférieure à une fréquence de coupure inférieure du deuxième oscillateur commandé (13), la différence de fréquence entre la fréquence de coupure supérieure du premier oscillateur commandé (12) et la fréquence de coupure inférieure du deuxième oscillateur commandé (13) correspondant à une fréquence de coupure inférieure du signal de fréquence à large bande (11, $f_{out}$).

**8.** Procédé (30) pour générer un signal de fréquence à large bande (11, $f_{out}$), le procédé (30) comprenant le fait de:

faire fonctionner (31a) un premier oscillateur commandé (12) et un deuxième oscillateur commandé (13) en utilisant une boucle à verrouillage de phase commune (14a, 54) sur la base d'un signal de tension ;
mélanger (32) les signaux de sortie des deux oscillateurs commandés (12, 13) pour générer le signal de fréquence à large bande (11, $f_{out}$) ; et
faire fonctionner (31a) les oscillateurs en utilisant la boucle à verrouillage de phase commune pour rétroaction du signal de fréquence à large bande (11, $f_{out}$), le signal de tension étant généré par la boucle à verrouillage de phase commune (14a, 54) sur la base du signal de fréquence à large bande rétroactionné (11, $f_{out}$), et
dans lequel le premier et le deuxième oscillateurs commandés (12, 13) sont configurés pour provoquer une variation de fréquence en sens inverse lors d'une modification du signal de tension.

**9.** Le procédé (30) selon la revendication 8,
dans lequel, lors du fonctionnement (31a) des oscillateurs pour la boucle à verrouillage de phase commune (14a, 24), un rapport entre une valeur de diviseur maximale d'un diviseur réglable (/K) de la boucle à verrouillage de phase commune (14a, 54) et une valeur de diviseur minimale du diviseur réglable (/K) ayant une valeur inférieure à 5 est utilisé.

Fig. 1

Fig. 1a

Fig. 2

30

31

Betreiben zweier gesteuerter
Oszillatoren

31a

Betreiben und Stabilisieren
der Oszillatoren über eine
gemeinsame
Phasenregelschleife

31b

Betreiben und Stabilisieren der
Oszillatoren über eine
Phasenregelschleife je
Oszillator

32

Mischen der Ausgangssignale der
beiden gesteuerten Oszillatoren zur
Erzeugung eines breitbandigen
Ausgangssignals

Fig. 3

Fig. 4

Fig. 5

Fig. 6

S4b.

CP_D

$V_{CP+}$

$V_{CP-}$

$F(s)$ $V_{tune}$ VCO-H $f_H$

$I(s)$ VCO-L $f_L$

$(V_{offset} - V_{tune})$

18

50b

$f_{out}$

Ref $f_{ref}$ /R PFD $\frac{Frac.}{Div.}$ /K /N

$\frac{f_{ref}}{R} = \frac{f_{out}}{N \times K}$

CP+ CP-

**Fig. 7**

24

Ref $f_{ref}$ /R PFD $\frac{Frac.}{Div.}$ /K

CP

$F(s)$

$I(s)$ VCO-L $f_L$

$V_{tune}$ VCO-H $f_H$

$(V_{offset} - V_{tune})$

18

50c

$f_{out}$

26

/N

$f_A$

VCO-A

$\frac{f_{ref}}{R} = \frac{\frac{f_{out}}{N} + f_A}{K}$

**Fig. 8**

**EP 3 683 968 B1**

**IN DER BESCHREIBUNG AUFGEFÜHRTE DOKUMENTE**

**In der Beschreibung aufgeführte Patentdokumente**

- US 20150295582 A1
- US 8264258 B1
- US 5267182 A
- US 5939951 A
- US 2005186918 A1